Europäisches Patentamt

European Patent Office

Office européen des brevets

(11) Publication number: **0 181 759**
A2

# (12) EUROPEAN PATENT APPLICATION

(21) Application number: 85308012.5

(22) Date of filing: 04.11.85

(51) Int. Cl.⁴: **H 01 H 71/12**
**G 01 R 19/145**

(30) Priority: 05.11.84 GB 8427902

(43) Date of publication of application:
21.05.86 Bulletin 86/21

(84) Designated Contracting States:
AT BE CH DE FR IT LI LU NL SE

(71) Applicant: BICC Public Limited Company
21, Bloomsbury Street
London, WC1B 3QN(GB)

(72) Inventor: Dhar, Pronab Kumar
7 Spurfield Hurstpark
East Molesey Surrey(GB)

(74) Representative: Ross Gower, Edward Lewis et al,
BICC plc Patents and Licensing Department 38 Ariel Way
Wood Lane
London W12 7DX(GB)

(54) Electric circuit breaker.

(57) A single or multi-pole electric circuit breaker has, associated with the busbar (1) of the or each pole, a thin film sensor (2) electrically insulated and spaced a predetermined fixed distance from a surface of the busbar (1). The thin film sensor (2) detects the magnetic field around the busbar to give an indication of the current passing therethrough. Signals from the thin film sensor (2) are interpreted by a microprocesor (3) which effects operation of a tripping mechanism (7), tripping the circuit breaker, if the signals fulfil preprogrammed tripping criteria.

The thin film sensor may be encapsulated in a moulded body (8) of electrically insulating plastics material. The moulded body (8) may itself be mounted on or in a spacer member such as a sleeve (13) to locate the thin film sensor (2) at a predetermined spacing from its associated busbar.

Fig.1.

Croydon Printing Company Ltd

Electric Circuit Breaker

This invention relates to single pole or multi-pole moulded-case electric circuit breakers of the kind having, associated with the or each pole, means which is responsive to a current in excess of the rated current of the circuit breaker and which is operatively coupled to a tripping mechanism for tripping the circuit breaker and causing circuit-breaking separation of a moving contact and an associated fixed contact.

It is an object of the present invention to provide, in an electric circuit breaker of the aforesaid kind, improved means for sensing a current in excess of the rated current of the circuit breaker, which improved current sensing means is substantialy simpler in design and therefore less expensive than current sensing means hitherto proposed and used and is less liable to mechanical fault.

According to the invention, there is provided an electric circuit breaker having one or more poles, the or each pole having a busbar, there being associated with the busbar of the or each pole of the circuit breaker a thin film sensor which is electrically insulated with respect to, and is spaced a predetermined fixed distance from a surface of, the busbar; electronic processing means to which the thin film sensor is electrically connected; and, for tripping the circuit breaker and causing circuit breaking separation of a moving contact and an associated fixed contact, a

2.

tripping mechanism to which the electronic processing means is operatively coupled, the arrangement being such that the thin film sensor detects the magnetic field around the busbar to give an indication of the current of the busbar and the electronic processing means interprets current data supplied by the thin film sensor and effects operation of the tripping mechanism if the current data fulfils preprogrammed tripping criteria.

The preprogrammed tripping criteria are the circumstances in which the electronic processing means initiates tripping of the circuit breaker.  Normally the tripping criteria will include any current surge producing a current above a predetermined amount.  In addition the tripping criteria may include smaller changes in current if sustained for a predetermined time.  Each current level may have a predetermined time which, if maintained, causes tripping of the circuit breaker.  The electronic processing means is reprogrammable to accept different tripping criteria for circuit breakers with different current ranges.

By a "thin film sensor" is meant a ferromagnetic thin film of such a composition and geometry that it has sensitive magnetoresistance  responses which can be used for the detection of magnetic fields.  Such thin film sensors are two-terminal devices which experience a change in their resistance when acted upon by a suitably orientated magnetic field.  The change in resistance is

3.

usually detected as a change in voltage across the sensor when it is applied with a constant current.

Preferably, to maintain the thin film sensor electrically insulated with respect to, and at a predetermined fixed distance from a surface of, its associated busbar, the thin film sensor is encapsulated in a moulded body of electrically insulating plastics material, which body is of predetermined fixed dimensions and can be secured to the busbar.

To enable a thin film sensor encapsulated in a moulded body of electrically insulating plastics material to be suitable for use in any one of a plurality of circuit breakers whose current ratings lie within a limited predetermined range, the moulded body of electrically insulating plastics material in which the thin film sensor is encapsulated may be mounted in or on a spacer member adapted to locate the body at a predetermined distance from the busbar appropriate to the particular current rating of a circuit breaker thereby to ensure that the current sensing means is of the required sensitivity. Conveniently the spacer member has a plurality of locations on or in which the moulded body can be mounted, thereby to permit the body to be mounted at any one of a plurality of different distances from the busbar. The spacer member may be in the form of a mounting board on which the moulded body may be located or alternatively in the form of a wedge-shaped member in which case the distance of the moulded body containing the thin-film sensor from the busbar can be varied according to the longitudinal location thereof.

Alternatively the moulded body is fitted within a sleeve of electrically insulating material of predetermined wall thickness appropriate to the particular rating of the circuit breaker. A plurality of sleeves of plastics insulating material, each having a bore of such a shape and size that the sleeve will be a tight fit on the moulded body, may be provided, each sleeve having a wall thickness different from that of each other sleeve so that the current sensing means may be readily modified for use with a circuit breaker of a particular current rating. To facilitate identification of an appropriate sleeve, the sleeves of a common wall thickness may all be of the same colour, which colour is different from that of sleeves of other wall thicknesses.

Where the circuit breaker is a multi-pole moulded-case electric circuit breaker, thin film sensors, one for each pole, may be encapsulated in a single moulded body of electrically insulating plastics material electrically connected to the electronic processing means.

Signal output of the improved current sensing means may be analogue or digital. Preferably the electronic processing means is a microprocessor.

Where an amplifier is required in association with each thin film sensor, this may be encapsulated in the moulded body of electrically insulating plastics material.

An electric circuit breaker according to the present invention may comprise one or more thin film sensors as the sole current sensing mechanism, or may alternatively include one or more thin film sensors in tandem with another known type of current sensor such as a toroidal core.

The invention will now be further described, by way of example only, with reference to the accompanying drawings; in which

Figure 1 is a schematic diagram of a part of a circuit breaker according to the invention;

Figure 2 is a view, including hidden detail, of one arrangement of sensor for use in the circuit breaker of Figure 1.

Figure 3 is a view, including hidden detail, of an alternative arrangement of sensors for use in the circuit breaker of Figure 1; and

Figure 4 is a pictorial view of yet another arrangement of sensors for use with the circuit breaker of Figure 1.

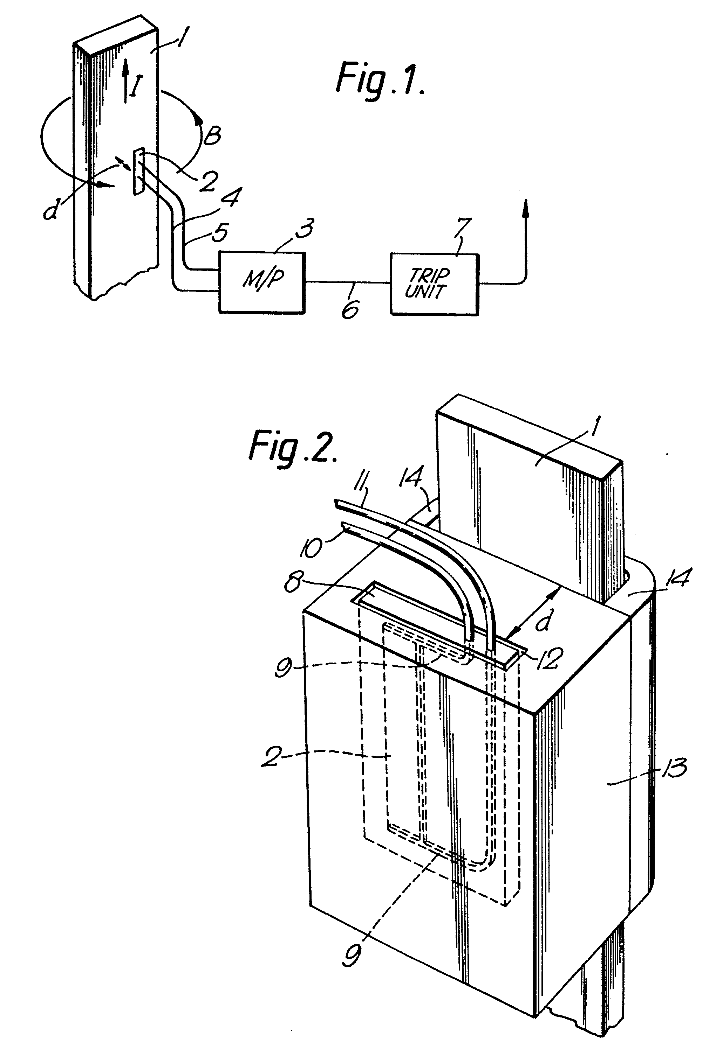

Referring to Figure 1 there is shown a busbar 1 of a circuit breaker which carries a current I thereby generating a magnetic field B. Adjacent the busbar 1, and separated therefrom by a small distance d, is a thin film sensor 2, electrically connected to a microprocessor 3 by means of leads 4 and 5. The microprocessor is in communication by means of line 6 with a trip unit 7 which is capable of interrupting the flow of current through the busbar 1, and other busbars if present.

The thin film detector 2 has a resistance dependent on the strength of the magnetic field B and hence the current I. The resistance of the sensor 2 is monitored by the microprocessor 3 which stores data relating to the current in the busbar 1. The microprocessor 3 compares the current data with preprogrammed tripping data, for example in a read only memory, to make a decision on whether to actuate the trip unit 7 to cause tripping of the circuit breaker.

Figure 2 shows one way in which the sensor 2 is located at a known distance d from the busbar 1. The thin film sensor 2 is encapsulated in a moulded body 8, typically of plastics material. Electrical conductors 9 project from the body 8 for connection to leads 10, 11.

The moulded body 8 is received within a slot 12 in a plastics sleeve 13 which is clipped on to the busbar 1 by means of arm portions 14.  The distance d by which the sensor 2 is separated from the busbar is therefore determined by the sleeve 13, and can be varied by exchanging the sleeve 13 for another of different wall thickness.

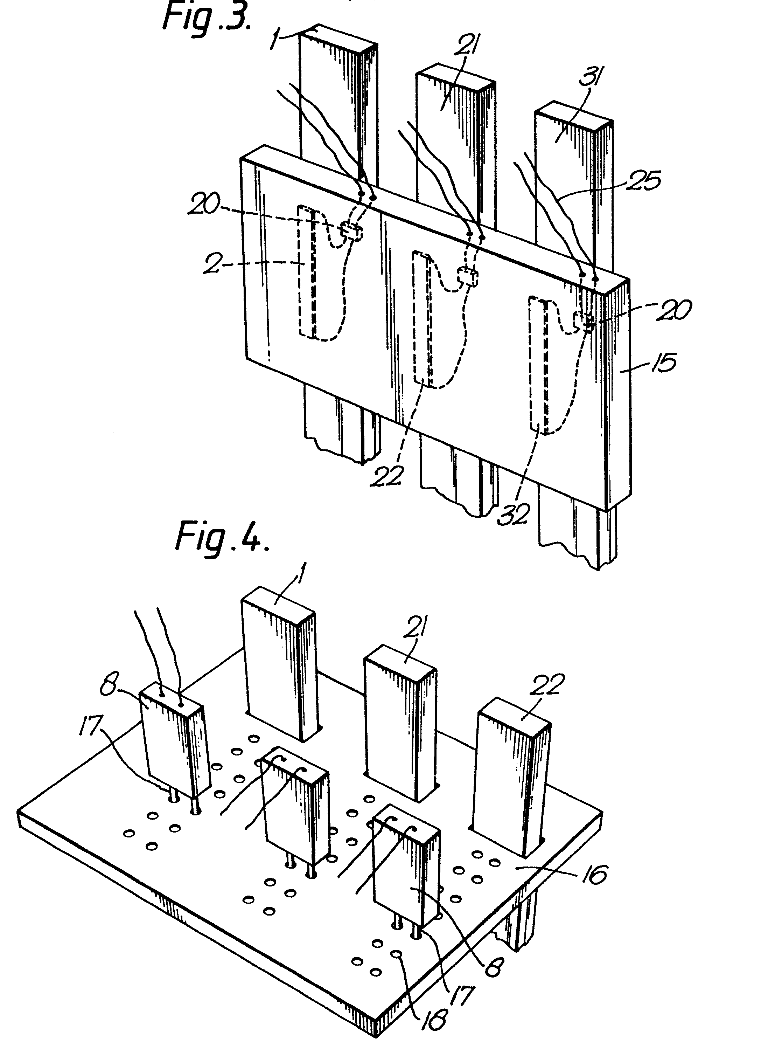

In Figure 3 there is shown three busbars 1, 21 and 31 as would be present in a 3-pole circuit breaker for use with a 3-phase current supply.  Adjacent the busbars is a single moulded body 15 in which is encapsulated three thin film sensors, 2, 22 and 32.  The body 15 is secured to the busbars by means not shown such that one sensor is adjacent each of the busbars.  Also encapsulated within the body 15 are amplifiers 20, through which signals from the sensors are passed before being fed to the microprocessor by means of leads 25 emerging from the body.  The distance of the sensors 2, 22, 32 from the busbars can be varied for different current ratings by constraining the moulded body 15 within a sleeve as described with reference to Figure 2.

Figure 4 shows the three busbars, 1, 21, 31 having a mounting board 16 secured thereto.  Thin film sensors, each encapsulated in an individual moulded body 8, are mounted on the board 16, pegs 17 on the moulded body 8 being received in holes 18 on the board.  The board 16 has a plurality of holes 18 to allow different

0181759

separations between the sensors and the busbars to be easily achieved.

It will be appreciated that a variety of other methods of mounting the sensors with respect to the busbars may be used without departing from the scope of the invention. Providing for a variety of separations between sensor and busbar, permits the use of a particular thin film sensor for a variety of ranges of current, without producing undesired saturation of the sensor by too strong a magnetic field.

CLAIMS

1. An electric circuit breaker having one or more poles, the or each pole having a busbar (1); and a tripping mechanism (7) for tripping the circuit breaker and causing circuit breaking separation of a moving contact and an associateed fixed contact, characterised in that associated with the busbar (1) of one or more poles of the circuit breaker is a thin film sensor (2) which is electrically insulated with respect to, and spaced a predetermined fixed distance from a surface of the busbar (1); and there is provided electronic processing means (3) operatively coupled to the tripping mechanism (7) and electrically connected to the thin film sensor (2); the arrangement being such that the thin film sensor (2) detects a magnetic field around the busbar (1) to give an indication of the current of the busbar and the electronic processing means (3) interprets current data supplied by the thin film sensor (2) and effects operation of the tripping mechanism (7) if the current data fulfils pre-programmed tripping criteria.

2. A circuit breaker according to Claim 1 characterised in that the thin film sensor (2) is encapsulated in a moulded body (8) of electrically insulating material adapted to be secured to the busbar (1).

3. A circuit breaker according to Claim 2 characterised in that the moulded body (8) is formed of an electrically insulating plastics material.

4. A circuit breaker according to Claim 2 or Claim 3 characterised in that the moulded body (8) is mounted on or in a spacer member (13, 16) adapted to locate the body at a predetermined distance from the busbar (1).

5. A circuit breaker according to Claim 4 characterised in that the spacer member (16) has a plurality of locations (18) on or in which the moulded body (8) can be mounted, thereby to permit the body to be mounted at any one of a a plurality of different distances from the busbar (1).

6. A circuit breaker according to Claim 4 characterised in that the moulded body (8) is fitted within a sleeve (13) of electrically insulating material of a predetermined wall thickness.

7. A circuit breaker according to any of Claims 2 to 6 characterised in that there is additionally provided an amplifier (20) encapsulated within the moulded body.

8. A circuit breaker according to Claim 1 having two or more poles characterised in that it has a plurality of thin film sensors (2), one for each pole, encapsulated in a single moulded body (15) of electrically insulating material.

9. A circuit breaker according to any of Claims 1 to 8 characterised in that the electronic processing means is a micro- processor (3).

0181759

Fig.1.

Fig.2.

Fig. 3.

Fig. 4.

0181759

2/2